# FASCICULE DE BREVET EUROPEEN

(11) **EP 2 184 855 B1**
(45) Date de publication et mention de la délivrance du brevet: **21.09.2011**
(21) Numéro de dépôt: 09173434.3
(22) Date de dépôt: 19.10.2009
(51) Int. Cl.: H03K 17/06, H03K 19/00, H03K 19/003

(54) **Circuit intégré avec polarisation de grille de transistor de puissance contrôlée par le courant de fuite**
Integrierte Schaltung mit leckstromabhängiger Basisvorspannung eines Leistungstransistors
Integrated circuit with leakage current dependent gate polarisation of a power transisitor

(30) Priorité: 07.11.2008 FR 0806228
(43) Date de publication de la demande: 12.05.2010
(73) Titulaire: Commissariat à l'Énergie Atomique et aux Énergies Alternatives, 75015 Paris (FR)
(72) Inventeur: Valentian, Alexandre, 38120 Saint Egrève (FR); Thomas, Olivier, 38420 Revel (FR)
(74) Mandataire: Guérin, Michel

(56) Documents cités:
- FR-A- 2 908 555
- US-A1- 2006 006 929
- US-B1- 6 940 307

## Description

L'invention concerne les circuits intégrés électroniques capables de fonctionner soit en mode actif soit en mode de veille et d'avoir, en mode de veille, une très faible consommation de courant.

Ces circuits sont nécessaires notamment dans les applications où l'alimentation est fournie par une batterie ou une pile (téléphones portables, appareils photographiques, ordinateurs portables, etc.), afin de ne pas consommer inutilement l'énergie de la source d'alimentation.

Dans ces applications, on réalise en général les circuits en technologie CMOS (métal oxyde semiconducteur complémentaire), permettant une consommation plus faible que d'autres technologies.

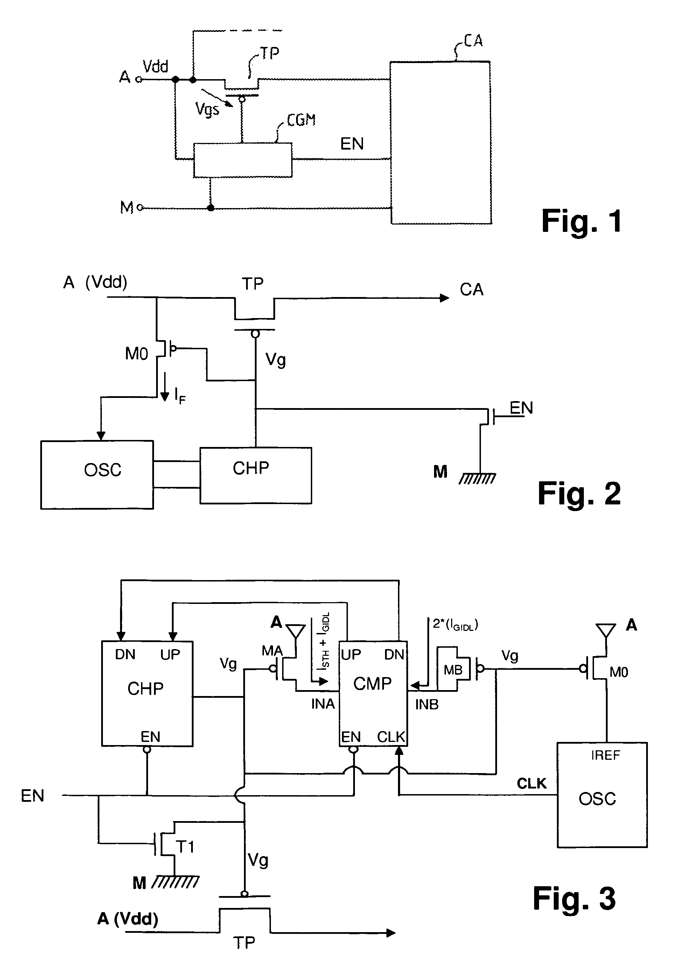

Pour passer d'un mode actif à une mode de veille, on prévoit en général dans le circuit intégré, comme on le voit sur la figure 1, un transistor MOS de puissance TP interposé en série entre l'une des bornes d'alimentation A ou M du circuit intégré et la partie active du circuit (CA) ; ce transistor est contrôlé par un circuit CGM de gestion de mode qui établit sur la grille du transistor une tension ou une autre selon que le circuit intégré est en mode actif ou en veille ; la fonction de ce transistor de puissance est double :
- en mode actif : il est rendu fortement conducteur et laisse passer tout le courant nécessaire au circuit actif, avec une chute de tension minimale donc sans consommation de puissance inutile ;
- en mode de veille : il est bloqué pour interrompre le courant de la source d'alimentation vers le reste du circuit intégré.

Le transistor de puissance doit donc répondre à plusieurs contraintes : courant suffisamment élevé dans l'état passant ; très faible chute de tension dans l'état passant ; très faibles courants de fuite dans l'état bloqué ; et enfin, si possible, des dimensions aussi réduites que possible pour réduire l'encombrement sur le silicium du circuit intégré.

On a déjà proposé dans l'art antérieur divers types de transistors de puissance tentant de répondre à cet ensemble de contraintes. On en trouvera des exemples notamment dans les documents publiés suivants :

S. Mutoh et al., "1-V Power Supply High Speed Digital Circuit Technology with Multithreshold-voltage CMOS", IEEE Journal of Solid State Circuits, vol. 30, pp 847-854, Aug. 1995.

T. Inukai et al., "Boosted Gate OS (BGMOS): Device/Circuit Cooperation Scheme to Achieve Leakage-Free Giga-Scale Integration", Custom Integrated Circuits Conference, pp. 409-412, May 2000.

H. Kawaguchi et al., "A super Cut-Off CMOS (SCCMOS) Scheme for 0,5 V Supply Voltage with Picoampere Stand-by Current", IEEE Journal of Solid State Circuits, vol. 35 N°10, pp 1498-1501, Oct 2000.

Dans ce dernier document, on utilise un transistor de puissance à tension de seuil basse fournissant un courant élevé dans l'état passant et dont on réduit le courant de fuite en sur-polarisant la grille en inverse en mode de veille ; par sur-polarisation inverse on entend une polarisation à une tension plus basse que la borne la plus négative de la tension d'alimentation, pour un transistor NMOS, ou plus haute que la tension d'alimentation la plus positive pour un transistor PMOS.

Le type de transistor de puissance du document cité en dernier (SCCMOS) est celui qui présente le meilleur compromis entre la surface occupée (pour un courant donné dans l'état passant) et le courant de fuite dans l'état bloqué.

On constate que le courant de fuite, qui est d'abord dû au courant de conduction I_{STH} entre source et drain (courant sous le seuil I_{STH}) diminue exponentiellement lorsqu'on polarise plus négativement la grille (pour un NMOS) ; il peut devenir extrêmement faible, mais d'autres phénomènes induisent d'autres courants de fuite qui peuvent croître avec la tension de sur-polarisation.

On a donc déjà proposé des circuits de contrôle de sur-polarisation inverse de grille, qui établissent une tension de sur-polarisation inverse ni trop faible ni trop élevée. Ces circuits de contrôle sont sophistiqués, ils incluent des sources de courant, des comparateurs, des pompes de charge élévatrices de tension, etc. Ils requièrent eux-mêmes de l'énergie pour fonctionner, ce qui va dans le sens contraire d'une réduction de la consommation dans l'état de repos. De tels circuits sont proposés par exemple dans la publication suivante : "Automatic Gate Biasing of an SCCMOS Power Switch Achieving Maximum Leakage Reduction and Lowering Leakage Current Variability", de A. Valentian et E. Beigne, dans IEEE Journal of Solid-State Circuits, Volume 43, N°7, Juillet 2008 Page(s):1688 - 1698.

On notera aussi qu'on a déjà proposé dans l'art antérieur des circuits de contrôle de polarisation directe de grille, utilisant des pompes de charge fonctionnant à une fréquence variable : voir brevet US 5 258 662.

Un but de l'invention est de proposer un circuit de contrôle de la sur-polarisation inverse de grille qui ait une consommation d'énergie minimale.

Selon l'invention, on propose un circuit-intégré comportant un transistor de puissance en série entre une borne d'alimentation et un circuit d'utilisation, et un circuit de polarisation de grille pour appliquer à la grille du transistor de puissance un potentiel de polarisation directe pour rendre le transistor conducteur et un potentiel de sur-polarisation inverse pour bloquer fortement le transistor, le circuit de polarisation de grille comprenant une pompe de charge élévatrice de tension fournissant à la grille du transistor de puissance un potentiel de sur-polarisation inverse, un oscillateur pour appliquer à la pompe de charge des impulsions à la fréquence de l'oscillateur, caractérisé en ce que l'oscillateur de la pompe de charge est un oscillateur à fréquence contrôlée par un courant, et en ce que le courant de contrôle de l'oscillateur est un courant de drain d'un transistor auxiliaire, de caractéristiques technologiques représentatives du transistor de puissance, la grille et la source du transistor auxiliaire étant reliées à la grille et à la source respectivement du transistor de puissance.

Par "caractéristiques technologiques représentatives du transistor de puissance", on entend essentiellement le fait que le transistor auxiliaire est réalisé avec les mêmes étapes et paramètres technologiques, en particulier la même tension de seuil (donc le même niveau de dopage de canal) que le transistor de puissance.

Le transistor auxiliaire est de préférence beaucoup plus petit que le transistor de puissance (si possible au moins 10 fois plus petit) ; il a de préférence une longueur identique à celle du transistor de puissance (qui est en pratique aussi courte que possible en respectant les contraintes de la technologie utilisée), et une largeur de grille beaucoup plus petite.

Corrélativement, outre le circuit intégré ainsi défini, l'invention propose un procédé de contrôle du courant de fuite d'un transistor de puissance inséré en série entre une borne d'alimentation et un circuit d'utilisation, dans lequel la grille du transistor de puissance reçoit une tension de polarisation directe en mode de conduction et une tension de sur-polarisation inverse en mode de blocage, le procédé comprenant l'utilisation d'un oscillateur et d'une pompe de charge élévatrice de tension recevant des impulsions de l'oscillateur pour produire la tension de sur-polarisation inverse, caractérisé en ce que l'oscillateur est un oscillateur à fréquence contrôlée par un courant, et le courant de contrôle de l'oscillateur est un courant de drain d'un transistor auxiliaire, de caractéristiques technologiques représentatives du transistor de puissance, dont la grille et la source sont reliées respectivement à la grille et à la source du transistor de puissance.

Ainsi, le principe de base du fonctionnement est le suivant : le transistor auxiliaire reçoit la même tension de sur-polarisation inverse que le transistor de puissance. Il laisse donc passer seulement un courant de fuite et c'est ce courant de fuite qui commande la fréquence de l'oscillateur. Si le courant de fuite est élevé (et il est alors élevé aussi bien pour le transistor de puissance et le transistor auxiliaire), la fréquence de l'oscillateur augmente et la tension de sur-polarisation inverse augmente aussi, ce qui tend à réduire le courant de fuite ; la fréquence de l'oscillateur se réduit en conséquence et, de ce fait, la tension de sur-polarisation inverse augmente moins vite ou cesse d'augmenter.

Ce principe fonctionne bien sans qu'il soit besoin de circuits de régulation complémentaire dans la mesure où les variations de tension de sur-polarisation inverse restent dans une gamme limitée (une gamme dans laquelle le courant de fuite diminue tant que la tension de sur-polarisation inverse augmente). La fréquence de l'oscillateur se stabilise à une valeur relativement faible, ce qui réduit la consommation d'énergie en mode de veille par rapport à la consommation d'un circuit dont l'oscillateur et la pompe de charge fonctionneraient à fréquence fixe.

Cependant, un deuxième phénomène doit être pris en compte ; il s'agit de l'apparition d'un courant de drain induit par la grille (I_{GIDL}) du fait de la tension relativement élevée de la grille : en polarisant la grille en inverse, il apparaît un courant de fuite non plus entre drain et source mais entre drain et substrat du circuit intégré. Typiquement, dans la configuration de la figure 1 où le transistor de puissance TP est un transistor PMOS dont la source est reliée à la borne d'alimentation la plus positive A, la grille est portée à un potentiel encore plus positif en mode de blocage, alors que le drain va rester pratiquement au potentiel de la borne M qui est le potentiel bas de l'alimentation. Un électron de la bande de valence peut passer par effet tunnel dans la bande de conduction, ce qui génère des paires électrons-trous là où la grille surplombe le bord du drain, à cause du fort champ électrique qui existe verticalement à cet endroit entre grille et drain ; d'autres paires électrons trous peuvent aussi être générées thermiquement dans le drain ; une fois que les paires électrons-trous ont été générées, les porteurs majoritaires (électrons pour un transistor NMOS, trous pour un transistor PMOS) se dirigent vers le drain et les porteurs minoritaires se dirigent vers le substrat à cause du champ électrique latéral. Il y a donc un courant drain-substrat ; la présence de ce courant tend à maintenir la présence d'une zone de déplétion et le processus de génération de paires électrons-trous par effet tunnel peut continuer sans créer de couche d'inversion. Ce courant I_{GIDL} ou courant de drain induit par la grille augmente significativement lorsque la tension inverse entre grille et drain augmente ; l'augmentation est sensiblement exponentielle.

La sur-polarisation inverse de grille engendre donc un courant de fuite additionnel I_{GIDL} pour la batterie d'alimentation du circuit, et ce courant croît fortement avec le niveau de sur-polarisation. Cela veut dire que si on augmente trop la tension grille-source en négatif (NMOS) ou en positif (PMOS), la forte réduction du courant de fuite entre source et drain ne sert plus à rien car une autre source de fuites devient prédominante.

En résumé, le courant de fuite directe entre source et drain diminue avec la tension de sur-polarisation inverse, alors que le courant de fuite supplémentaire I_{GIDL} augmente avec la tension de sur-polarisation inverse. On prévoit donc de préférence, selon un perfectionnement important du procédé selon l'invention, que les impulsions issues de l'oscillateur sont appliquées à la pompe de charge sous le contrôle d'un comparateur de courants qui compare les courants de fuite d'un deuxième et un troisième transistors auxiliaires supplémentaires de caractéristiques technologiques représentatives de celles du transistor de puissance, le deuxième transistor auxiliaire ayant sa source et sa grille reliées à la source et la grille du transistor de puissance et son drain relié à une première entrée du comparateur de courant, et le troisième transistor auxiliaire a sa grille reliée à la grille du transistor de puissance et sa source et son drain reliés entre eux et à une deuxième entrée du comparateur de courants.

Ainsi, le circuit de sur-polarisation inverse de grille selon l'invention comporte en outre des moyens pour empêcher un accroissement de potentiel de sur-polarisation en sortie de la pompe de charge au delà d'une certaine valeur ; cette valeur est de préférence celle qui rend égaux le courant de fuite directe I_{STH} (diminuant lors de l'accroissement de la tension de sur-polarisation) et le courant de fuite supplémentaire I_{GIDL} (augmentant avec la tension sur-polarisation). Le comparateur de courants qui est utilisé à cet effet reçoit un premier courant et un deuxième courant, qui sont dérivés des différents courants de fuite de transistors auxiliaires identiques, semblables au transistor de puissance mais plus petits que lui, ces courants de fuite s'égalisant lorsque le courant de fuite directe I_{STH} devient égal au courant de fuite supplémentaire I_{GIDL}.

En pratique, le premier courant est fourni par un deuxième transistor auxiliaire qui est monté de telle manière qu'il dirige vers une première entrée du comparateur de courant un courant qui est la somme de tous les courants de fuite de ce transistor ; et le deuxième courant est fourni par un troisième transistor auxiliaire de mêmes dimensions que le deuxième, qui est monté de telle manière qu'il dirige vers une deuxième entrée du comparateur un courant qui est deux fois le courant de drain induit par la grille. Les transistors étant identiques, la différence entre ces courants s'annule lorsque le courant de fuite sous la grille I_{STH} est égal au courant de drain induit par la grille I_{GIDL}.

D'autres caractéristiques et avantages de l'invention apparaîtront à la lecture de la description détaillée qui suit et qui est faite en référence aux dessins annexés dans lesquels :
- la figure 1 représente la configuration d'un circuit ayant un mode actif et un mode de veille, avec un transistor de puissance en série pour contrôler le passage d'un mode à l'autre ;
- la figure 2, représente le principe d'un circuit selon l'invention ;
- la figure 3, représente une réalisation préférée qui tient compte du courant de fuite induit par la grille (I_{GIDL}) ;
- la figure 4 représente un comparateur de courants ;
- la figure 5 représente un circuit fournissant un signal de précharge ;
- la figure 6 représente un circuit de pompe de charge élévatrice de tension.

La partie active principale CA du circuit intégré de la figure 1 possède une fonctionnalité quelconque (par exemple de téléphonie pour un téléphone, de prise de vue pour un appareil photographique, etc.). Cette fonctionnalité est pourvue d'un mode actif et d'un mode de veille. Le mode de veille peut typiquement s'activer tout seul après un temps de non utilisation déterminé, ou encore il peut s'activer sur commande d'un utilisateur.

Il y a deux bornes d'alimentation A et M qui alimentent directement les circuits qui doivent rester alimentés en permanence et qui alimentent indirectement le circuit actif CA, à travers un transistor de puissance TP en série entre une des bornes d'alimentation et le circuit CA.

Dans le mode de veille, l'alimentation du circuit actif CA est coupée par le transistor. Seuls restent alimentés quelques circuits à faible consommation, par exemple un circuit (non représenté) pour détecter une demande de retour au mode actif et un circuit de gestion de mode CGM qui commande la grille du transistor de puissance.

Dans ce qui suit on considère que la borne d'alimentation A est une borne d'alimentation positive à une tension Vdd, la borne M est une borne d'alimentation qu'on considérera comme une borne de masse (potentiel zéro), donc plus négative que la borne A ; le transistor de puissance TP est un transistor PMOS et sa source est reliée à la borne A. On doit comprendre cependant que le transistor TP pourrait être un transistor NMOS inséré sur l'autre conducteur d'alimentation, c'est-à-dire entre la borne M et le circuit actif, la source du transistor étant reliée à la borne M.

Le drain du transistor TP est relié au circuit actif CA qui est le circuit d'utilisation du courant transmis par le transistor de puissance ; ce circuit ne reçoit un courant d'alimentation que si le transistor TP est conducteur.

Le circuit de gestion de mode CGM a donc deux états de fonctionnement possible : dans un premier état correspondant au mode actif, il établit une tension nulle (tension de la borne M) sur la grille du transistor TP, pour rendre le transistor franchement conducteur avec une très faible chute de tension ; dans un deuxième état correspondant au mode de veille, il établit une tension de blocage sur la grille du transistor afin que le transistor ne laisse plus passer de courant. Le circuit de gestion de mode CGM est donc essentiellement un circuit de polarisation de la grille du transistor TP. Il comprend une entrée EN qui définit le mode et qui peut provenir du circuit CA ou d'ailleurs.

Si le transistor de puissance TP a une tension de seuil assez élevée (en valeur absolue), il suffit que la tension appliquée à la grille en mode de veille soit égale à la tension sur la borne A pour bloquer fortement le passage du courant, et dans ce cas le circuit de gestion de mode CGM peut être extrêmement simple à réaliser puisqu'il suffit de porter la grille soit au potentiel de la masse M soit au potentiel de la borne A. Mais l'inconvénient est qu'un transistor de puissance réalisé dans une technologie qui lui donne une tension de seuil élevé doit avoir une taille assez grande, faute de quoi la chute de tension en direct (pour un courant d'alimentation donné) serait trop élevée ; cette taille assez grande est préjudiciable en termes de coûts de fabrication.

Si le transistor de puissance TP a une tension de seuil plus basse (obtenue par un choix de dopage approprié du canal), autorisant une taille de transistor plus faible, alors le blocage risque d'être imparfait si on se contente d'appliquer sur la grille le même potentiel que sur la source.

C'est pourquoi, dans ce cas, le circuit CGM est conçu pour appliquer à la grille une tension de sur-polarisation inverse encore plus positive que la tension Vdd qui est présente sur la borne A.

La figure 2 représente un exemple de mise en oeuvre simple de l'invention dans le cas où le transistor de puissance est un transistor PMOS monté comme à la figure 1.

Le circuit a une entrée EN pour recevoir un signal logique de commande de mode. Si le mode est actif, la commande EN est au niveau logique haut (1) ; elle rend conducteur un transistor NMOS T1 qui met la grille du transistor TP à la masse, rendant conducteur ce dernier (PMOS). Si le mode est le mode de veille, la commande EN est au niveau logique bas (0), bloquant le transistor T1 et activant un circuit de sur-polarisation inverse de grille qui applique à la grille de TP un potentiel Vg supérieur au potentiel Vdd de la borne A.

Ce circuit de sur-polarisation comprend principalement un oscillateur OSC à fréquence variable et une pompe de charge CHP élévatrice de tension commandée par les impulsions issues de l'oscillateur. La pompe de charge fournit une tension de sortie Vg qui croît d'autant plus que la fréquence F des impulsions fournies par l'oscillateur est plus élevée et qui augmente moins vite ou même diminue lorsque la fréquence diminue.

L'oscillateur est un oscillateur à fréquence contrôlée par un courant I_{F} : plus le courant est élevé, plus la fréquence est haute ; inversement, plus le courant est faible, plus la fréquence est basse.

Il résulte de cela que plus le courant d'alimentation I_{F} est élevé, plus la tension de sur-polarisation inverse Vg en sortie de la pompe de charge tend à augmenter, et que lorsque ce courant diminue, la tension de sur-polarisation inverse augmente moins vite ou cesse d'augmenter, ou même tend à diminuer.

On prévoit selon l'invention que le courant I_{F} est fourni par un transistor auxiliaire MO ayant des caractéristiques technologiques représentatives de celles du transistor de puissance mais de plus petite taille pour limiter la consommation de courant ; par l'expression "caractéristiques technologiques représentatives", on entend essentiellement le fait qu'il est réalisé avec les mêmes étapes et paramètres technologiques, en particulier la même tension de seuil (donc le même niveau de dopage de canal). Il est de préférence au moins dix fois plus petit que le transistor de puissance TP et son courant de fuite est réduit dans la même proportion ; sa longueur est de préférence identique à celle du transistor de puissance TP et c'est donc s a largeur qui est au moins dix fois plus petite. La longueur du transistor de puissance est en principe la plus courte possible, dans les limites acceptables en fonction de la technologie imposée, pour que sa résistance interne soit aussi faible que possible.

Le transistor M0 reçoit sur sa grille et sur sa source les mêmes potentiels qui sont respectivement appliqués à la grille et à la source du transistor de puissance. Par conséquent, en mode de veille, il reçoit aussi une tension de sur-polarisation inverse de grille Vg. Il est donc fortement bloqué et il est parcouru seulement par son courant de fuite, lié à la tension de sur-polarisation inverse Vg. Le courant de commande I_{F} est donc le courant de fuite du transistor auxiliaire, proportionnel au courant de fuite du transistor de puissance TP.

La tension de sur-polarisation inverse Vg se stabilise autour d'une valeur suffisamment élevée au-delà de laquelle une nouvelle augmentation de tension de polarisation ne diminue pas significativement le courant de fuite I_{F}, ou au-delà de laquelle une diminution du courant de fuite I_{F} ne diminue pas significativement la fréquence.

Selon un mode de réalisation perfectionné, représenté à la figure 3, on prend en compte le fait que le courant de fuite global du transistor de puissance diminue jusqu'à une certaine valeur Vg₀ de la tension de sur-polarisation inverse mais augmente ensuite au fur et à mesure que Vg croît, de sorte qu'une polarisation optimale est celle pour laquelle le courant de fuite passe par un minimum.

On a montré, dans la demande de brevet FR 2 908 555 que ce minimum était situé sensiblement à la tension Vg₀ pour laquelle le courant de fuite direct entre drain et source (I_{STH}) était sensiblement égal au courant de drain induit par la grille (I_{GDL}), et on a montré comment le point d'égalité pouvait être trouvé en utilisant un comparateur de courants qui compare le courant de fuite global (I_{STH} + I_{GIDL}) d'un premier transistor auxiliaire avec un double courant de fuite induit par la grille (2.I_{GIDL}) dans un deuxième transistor auxiliaire identique au précédent. Le comparateur de courant décrit dans ce brevet antérieur fournissait des impulsions dérivées d'un oscillateur à fréquence fixe.

Dans la présente invention, on insère ce comparateur de courant CMP entre l'oscillateur OSC à fréquence contrôlée par le courant de fuite du transistor auxiliaire M0 et la pompe de charge CHP ; le comparateur de courant délivre des impulsions UP et DN à la fréquence variable de l'oscillateur ; ces impulsions sont destinées à des entrées UP et DN de la pompe de charge.

Le comparateur de courant CMP reçoit sur une première entrée le courant de drain d'un deuxième transistor auxiliaire MA dont la source est reliée au même potentiel Vdd que la source du transistor de puissance et dont la grille reçoit la même tension de polarisation Vg que le transistor de puissance. Le comparateur reçoit sur une deuxième entrée le courant de source et le courant de drain induits par la grille d'un troisième transistor auxiliaire MB qui reçoit sur sa grille la tension Vg, et qui a sa source et son drain réunis (en potentiel flottant) et reliés à la deuxième entrée du comparateur. Les transistors auxiliaires MA et MB sont identiques entre eux et de préférence identiques au transistor auxiliaire M0, les trois transistors étant de caractéristiques technologiques représentatives du transistor de puissance mais de géométrie beaucoup plus petite.

Le comparateur CMP comporte en outre une entrée d'activation qui reçoit le signal de commande EN et qui permet d'autoriser son activation seulement en mode de veille. Il comporte une entrée INA et une entrée INB sur lesquelles sont appliqués respectivement les courants à comparer issus des transistors MA et MB. Le comparateur CMP reçoit également un signal d'horloge CLK à la fréquence F, issu de l'oscillateur à fréquence variable OSC, et il produit deux signaux complémentaires UP et DN à la fréquence F, ces signaux indiquant lequel des courants d'entrée du comparateur est le plus grand.

Dans l'exemple préférentiel de réalisation, les signaux UP et DN sont de brèves impulsions logiques complémentaires, produites à la fréquence d'horloge F, et leur effet est d'augmenter légèrement ou de diminuer légèrement la tension Vg à chaque impulsion d'horloge, de sorte que la tension Vg se stabilise à une valeur moyenne où les courants I_{STH} et I_{GIDL} sont égaux.

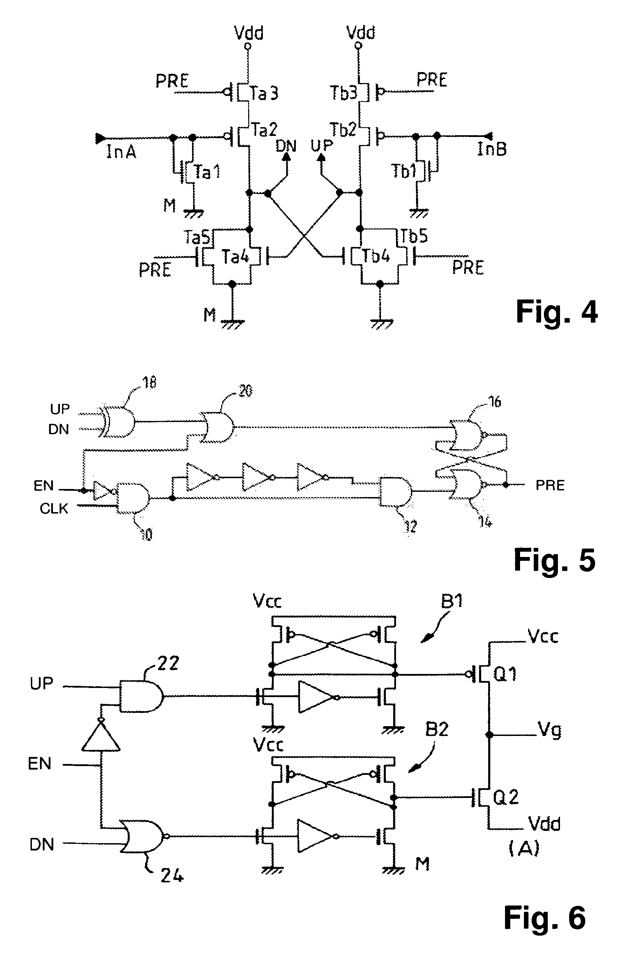

Le comparateur de courants utilisé peut être conforme à celui qui est représenté à la figure 4 et qui a été décrit en détail dans la demande de brevet FR 2 908 555.

Le comparateur de la figure 4 fonctionne de la manière suivante : l'entrée InA qui reçoit le courant de drain du transistor MA est reliée à la grille et au drain d'un transistor Ta1 NMOS monté en diode et ayant sa source reliée à la masse M ; l'entrée InA est reliée par ailleurs à la tension de grille d'un transistor PMOS Ta2. De même, l'entrée InB est reliée à un transistor NMOS Tb1 monté en diode entre InB et la masse M et à la grille d'un transistor PMOS Tb2.

Les transistors Ta2 et Tb2 font partie d'une paire de branches différentielles comportant chacune trois transistors en série Ta3, Ta2, et Ta4 (première branche) ou Tb3, Tb2, Tb4 (deuxième branche). Les transistors Ta3 et Tb3 sont des PMOS ayant leur source à la tension d'alimentation Vdd et leur grille commandée par un signal de précharge PRE. Le signal de précharge PRE, normalement au niveau 1, passe à zéro périodiquement (période de l'horloge CLK) pour déclencher une étape de comparaison.

Le transistor Ta2 est un PMOS qui a sa source reliée au drain de Ta3 et son drain relié au drain du transistor NMOS Ta4. La source du transistor Ta4 est à la masse. Les drains réunis de Ta2 et Ta4 forment la sortie DN du comparateur de courants. Le montage est le même pour la deuxième branche, les transistors Tb3, Tb2, Tb4 étant montés comme les transistors Ta3, Ta2, Ta4. Les drains réunis des transistors Tb2 et Tb4 forment la sortie complémentaire DN du comparateur de courants.

La grille du transistor Ta4 est reliée à la sortie UP et la grille de Tb4 est reliée à la sortie DN, ce croisement entre les branches différentielles formant une bascule instable tendant à faire passer très rapidement la sortie UP et la sortie DN dans des états logiques stables complémentaires si un léger déséquilibre de courants apparaît dans les branches différentielles.

Enfin, un transistor NMOS Ta5 en parallèle avec le transistor Ta4, et un transistor NMOS Tb5 en parallèle avec le transistor Tb4 sont commandés par le signal de précharge PRE pour maintenir les sorties UP et DN à zéro en dehors de la phase de comparaison définie par le signal PRE.

Les signaux produits par le comparateur de courant à la périodicité de l'impulsion de précharge (période de CLK) sont donc une impulsion brève sur l'une des deux sorties UP et DN, l'autre restant à zéro.

La figure 5 représente un circuit faisant partie du comparateur de courants, circuit qui permet d'élaborer périodiquement une impulsion de précharge PRE très brève ; le circuit utilise les signaux de sortie UP et DN du comparateur eux-mêmes pour interrompre l'impulsion de précharge.

Ce circuit reçoit l'horloge CLK et le signal de commande de mode EN. Pour le mode actif (EN=1) le signal PRE reste en permanence à 1 et il n'y jamais d'impulsion de précharge. UP et DN restent à zéro et le circuit de la figure 6 qui élabore la tension Vg laisse celle-ci flottante, de sorte que la valeur de la tension Vg, dictée par le transistor T1 de la figure 3, est nulle.

Pour le mode de veille (EN=0), la porte ET 10 transmet l'horloge CLK, et son complément retardé par des inverseurs en série, aux entrées d'une porte ET 12 de manière à produire une impulsion de déclenchement très brève sur le front montant du signal d'horloge ; cette impulsion, appliquée à une première entrée d'une bascule RS constituée par deux portes NI 14 et 16 bouclées l'une sur l'autre, fait passer à zéro le signal de sortie PRE de cette bascule, initialement à 1. Le processus de comparaison est alors déclenché dans le circuit comparateur de courants de la figure 4 et va générer un passage au niveau haut de la sortie UP ou la sortie DN.

Une porte OU-Exclusif 18 reçoit les signaux UP et DN et fournit un signal en général nul (car UP et DN sont le plus souvent à 0), qui passe à 1 à l'apparition du niveau haut sur la sortie UP ou DN du comparateur.

Dès que UP ou DN passe à 1, l'autre restant à zéro, la sortie de la porte OU-Exclusif 18 passe à 1 ; cette sortie est reliée à une entrée d'une porte OU 20 qui a EN=0 sur son autre entrée ; la sortie de la porte OU 20 passe de zéro à 1 ; ce passage à 1 fait rebasculer la bascule 14, 16 dans l'autre sens, ce qui remet le signal PRE à 1.

Le signal de précharge PRE reste à 1 jusqu'au front de montée suivant de l'horloge, ou reste à 1 si le circuit passe en mode actif (EN=1, blocage de l'horloge, maintien à zéro de la sortie de la porte 12 et à 1 de la sortie de la porte 20 donc immobilisation de la bascule RS).

Enfin, la figure 6 représente un exemple de pompe de charge élévatrice de tension pouvant fonctionner avec les signaux UP et DN obtenus à la fréquence variable F par le comparateur de la figure 4.

La pompe de charge CHP de la figure 6 a une entrée EN qui l'inhibe lorsque EN=1 c'est-à-dire en mode actif. Une porte ET 22 reçoit le complément de EN et l'entrée UP. Sa sortie fournit une brève impulsion de niveau logique 1 en mode de veille lorsque la comparaison de courant fournit une brève impulsion de niveau 1 sur l'entrée UP. Pour l'entrée DN, une porte NI 24 reçoit EN et l'entrée DN ; la sortie de la porte 24, normalement à 1, fournit une brève impulsion de niveau logique 0 en mode de veille lorsque la comparaison de courant fournit une brève impulsion de niveau 1 sur l'entrée DN.

Deux transistors Q1 (PMOS) et Q2 (NMOS) sont montés en série en push-pull analogique entre deux tensions continues Vdd et Vcc (Vcc supérieur à Vdd, Q1 connecté à Vcc, Q2 connecté à Vdd). Le point de jonction des drains de ces transistors fournit la tension de polarisation désirée Vg qui est la tension de sortie de la pompe de charge. Les drains sont en haute impédance en général car la grille de Q1 est normalement portée au potentiel le plus haut Vcc et la grille de Q2 est portée au potentiel de la masse (plus bas que Vdd).

S'il apparaît une impulsion de niveau 1 à la sortie de la porte ET 22, une bascule B1 commandée par cette sortie fait passer le potentiel sur la grille de Q1 à zéro. Q1 devient conducteur le temps de cette impulsion et tend à faire monter le potentiel Vg. Il n'y a pas d'action sur le transistor Q2 qui reste bloqué. A la fin de l'impulsion, le potentiel Vg a un peu monté.

Inversement, s'il apparaît une impulsion de niveau 1 à la sortie de la porte NI 24, une bascule B2 commandée par cette sortie fait passer le potentiel sur la grille de Q2 à Vcc (plus haut que Vdd, l'écart entre Vcc et Vdd étant supérieur à la tension de seuil de Q2). Q2 devient conducteur le temps de cette impulsion et tend à faire descendre le potentiel Vg. Il n'y a pas d'action sur le transistor Q1 qui reste bloqué. Quand l'impulsion s'interrompt, le potentiel Vg a un peu baissé.

Ce circuit de sur-polarisation inverse de grille doit utiliser non seulement le potentiel de masse (connexion à la borne M) et le potentiel Vdd (connexion à la borne A) mais aussi un potentiel Vcc plus élevé que celui de la borne A. Le potentiel Vcc plus élevé peut être obtenu soit directement si pour une raison ou une autre il est présent dans le circuit intégré, par exemple sur une borne de connexion extérieure, soit indirectement, par exemple par l'intermédiaire d'une pompe de charge. La production d'une tension plus élevée que la tension d'alimentation générale au moyen d'une pompe de charge est classique. A titre d'exemple, la tension d'alimentation Vdd est de 1,2 volt, norme pour de petits appareils portables, et la tension Vcc plus élevée peut être de 2,5 volts.

D'autres circuits peuvent être utilisés, à base de diodes et de capacités, pour réaliser la pompe de charge CHP.

## Revendications

1. Circuit-intégré comportant un transistor de puissance (TP) en série entre une borne d'alimentation (A) et un circuit d'utilisation (CA), et un circuit de polarisation de grille pour appliquer à la grille du transistor de puissance un potentiel de polarisation directe pour rendre le transistor conducteur et un potentiel de sur-polarisation inverse (Vg) pour bloquer fortement le transistor, le circuit de polarisation de grille comprenant une pompe de charge (CHP) fournissant à la grille du transistor de puissance un potentiel de sur-polarisation inverse, un oscillateur (OSC) pour appliquer à la pompe de charge des impulsions à la fréquence de l'oscillateur, **caractérisé en ce que** l'oscillateur est un oscillateur à fréquence contrôlée par un courant, et **en ce que** le courant de contrôle de l'oscillateur est un courant de drain d'un transistor auxiliaire (M0) de caractéristiques technologiques représentatives du transistor de puissance, la grille et la source du transistor auxiliaire étant reliées à la grille et à la source respectivement du transistor de puissance.

2. Circuit intégré selon la revendication 1, **caractérisé en ce que** le transistor auxiliaire est au moins dix fois plus petit que le transistor de puissance.

3. Circuit intégré selon la revendication 2, **caractérisé en ce que** le transistor auxiliaire a une longueur de grille identique à celle du transistor de puissance.

4. Circuit intégré selon l'une des revendications 1 à 3, **caractérisé en ce que** le circuit de polarisation de grille comporte un comparateur de courants (CMP) comparant les courants de fuite d'un deuxième (MA) et d'un troisième (MB) transistors auxiliaires de caractéristiques technologiques représentatives de celles du transistor de puissance, le deuxième transistor auxiliaire ayant sa source et sa grille reliées à la source et la grille du transistor de puissance et son drain relié à une première entrée du comparateur de courant, et le troisième transistor auxiliaire a sa grille reliée à la grille du transistor de puissance et sa source et son drain reliés entre eux et à une deuxième entrée du comparateur de courants.

5. Circuit intégré selon la revendication 4, **caractérisé en ce que** le comparateur de courants reçoit une fréquence issue de l'oscillateur et fournit à la pompe de charge des impulsions complémentaires à la fréquence de l'oscillateur, en fonction du résultat de la comparaison.

6. Circuit intégré selon l'une des revendications 4 et 5, **caractérisé en ce que** les deuxième et troisième transistors sont identiques, et au moins 10 fois plus petits que le transistor de puissance.

7. Procédé de contrôle du courant de fuite d'un transistor de puissance (TP) inséré en série entre une borne d'alimentation (A) et un circuit d'utilisation (CA), dans lequel la grille du transistor de puissance reçoit une tension de polarisation directe en mode de conduction et une tension de sur-polarisation inverse (Vg) en mode de blocage, le procédé comprenant l'utilisation d'un oscillateur (OSC) et d'une pompe de charge (CHP) recevant des impulsions de l'oscillateur pour produire la tension de sur-polarisation inverse, **caractérisé en ce que** l'oscillateur est un oscillateur à fréquence contrôlée par un courant, et le courant de contrôle (Ic) de l'oscillateur est un courant de drain d'un transistor auxiliaire (M0), de caractéristiques technologiques représentatives du transistor de puissance, dont la grille et la source sont reliées respectivement à la grille et à la source du transistor de puissance.

8. Procédé de contrôle de courant de fuite selon la revendication 7, **caractérisé en ce que** les impulsions issues de l'oscillateur (OSC) sont appliquées à la pompe de charge (CHP) sous le contrôle d'un comparateur de courants (CMP) qui compare les courants de fuite d'un deuxième (MA) et un troisième (MB) transistors auxiliaires de caractéristiques technologiques représentatives de celles du transistor de puissance, le deuxième transistor auxiliaire ayant sa source et sa grille reliées à la source et la grille du transistor de puissance et son drain relié à une première entrée du comparateur de courant, et le troisième transistor auxiliaire ayant sa grille reliée à la grille du transistor de puissance et sa source et son drain reliés entre eux et à une deuxième entrée du comparateur de courants.

## Claims

1. Integrated circuit comprising a power transistor (TP) in series between a supply terminal (A) and a use circuit (CA), and a gate bias circuit for applying a forward bias potential to the gate of the power transistor in order to turn the transistor on and a reverse overbias potential (Vg) for strongly blocking the transistor, the gate bias circuit comprising a charge pump (CHP) delivering a reverse overbias potential to the gate of the power transistor, and an oscillator (OSC) for applying pulses at the frequency of the oscillator to the charge pump, **characterized in that** the oscillator is an oscillator having its frequency controlled by a current and **in that** the oscillator control current is a drain current of an auxiliary transistor (M0) having technological characteristics representative of the power transistor, the gate and the source of the auxiliary transistor being connected to the gate and to the source of the power transistor, respectively.

2. Integrated circuit according to Claim 1, **characterized in that** the auxiliary transistor is at least ten times smaller than the power transistor.

3. Integrated circuit according to Claim 2, **characterized in that** the auxiliary transistor has a gate length identical to that of the power transistor.

4. Integrated circuit according to one of Claims 1 to 3, **characterized in that** the gate bias circuit comprises a current comparator (CMP) which compares the leakage currents of second (MA) and third (MB) auxiliary transistors having technological characteristics representative of those of the power transistor, the second auxiliary transistor having both its source and its gate connected to the source and the gate of the power transistor and its drain connected to a first input of the current comparator, and the third auxiliary transistor having its gate connected to the gate of the power transistor and both its source and its drain connected together and connected to a second input of the current comparator.

5. Integrated circuit according to Claim 4, **characterized in that** the current comparator receives a frequency from the oscillator and delivers complementary pulses at the frequency of the oscillator to the charge pump depending on the result of the comparison.

6. Integrated circuit according to either of Claims 4 and 5, **characterized in that** the second and third transistors are identical and at least ten times smaller than the power transistor.

7. Method of controlling the leakage current of a power transistor (TP) inserted in series between a supply terminal (A) and a use circuit (CA), in which the gate of the power transistor receives a forward bias voltage in conducting mode and a reverse overbias voltage (Vg) in blocking mode, the method comprising the use of an oscillator (OSC) and of a charge pump (CHP) receiving pulses from the oscillator in order to produce the reverse overbias voltage, **characterized in that** the oscillator is an oscillator having its frequency controlled by a current, and the control current (Ic) of the oscillator is a drain current of an auxiliary transistor (M0), having technological characteristics representative of the power transistor, the gate and the source of which are connected to the gate and to the source of the power transistor, respectively.

8. Leakage current control method according to Claim 7, **characterized in that** the pulses from the oscillator (OSC) are applied to the charge pump (CHP) under the control of a current comparator (CMP) which compares the leakage currents of second (MA) and third (MB) auxiliary transistors having technological characteristics representative of those of the power transistor, the second auxiliary transistor having both its source and its gate connected to the source and the gate of the power transistor and its drain connected to a first input of the current comparator, and the third auxiliary transistor having its gate connected to the gate of the power transistor and both its source and its drain connected together and connected to a second input of the current comparator.

## Patentansprüche

1. Integrierte Schaltung, die Folgendes umfasst: einen Leistungstransistor (TP) in Serie zwischen einem Versorgungsanschluss (A) und einem Verbraucherkreis (CA), und eine Gate-Vorspannungsschaltung, um an das Gate des Leistungstransistors eine Vorspannung in Durchlassrichtung, um den Transistor leitend zu machen, und eine Übervorspannung in Sperrrichtung (Vg) anzulegen, um den Transistor stark zu sperren, wobei die Gate-Vorspannungsschaltung Folgendes umfasst: eine Ladungspumpe (CHP), um eine Übervorspannung in Sperrrichtung an das Gate des Leistungstransistors anzulegen, einen Oszillator (OSC), um Impulse mit der Frequenz des Oszillators an die Ladungspumpe anzulegen, **dadurch gekennzeichnet, dass** der Oszillator ein Oszillator mit einer durch einen Strom geregelten Frequenz ist, und **dadurch**, dass der Steuerstrom des Oszillators ein Drainstrom eines Hilfsoszillators (M0) mit technischen Kennwerten ist, die für den Leistungstransistor repräsentativ sind, wobei das Gate und die Source des Hilfstransistors jeweils mit dem Gate bzw. der Source des Leistungstransistors verbunden sind.

2. Integrierte Schaltung nach Anspruch 1, **dadurch gekennzeichnet, dass** der Hilfstransistor wenigstens zehnmal kleiner ist als der Leistungstransistor.

3. Integrierte Schaltung nach Anspruch 2, **dadurch gekennzeichnet, dass** der Hilfstransistor eine Gate-Länge hat, die mit der des Leistungstransistors identisch ist.

4. Integrierte Schaltung nach einem der Ansprüche 1 bis 3, **dadurch gekennzeichnet, dass** die Gate-Vorspannungsschaltung einen Stromkomparator (CMP) umfasst, der die Leckströme eines zweiten (MA) und eines dritten (MB) Hilfstransistors vergleicht, die technische Kennwerte haben, die für die des Leistungstransistors repräsentativ sind, wobei die Source und das Gate des zweiten Hilfstransistors mit der Source und dem Gate des Leistungstransistors verbunden sind und sein Drain mit einem ersten Eingang des Stromkomparators verbunden ist, und wobei das Gate des dritten Hilfstransistors mit dem Gate des Leistungstransistors verbunden ist und seine Source und sein Drain miteinander und mit einem zweiten Eingang des Stromkomparators verbunden sind.

5. Integrierte Schaltung nach Anspruch 4, **dadurch gekennzeichnet, dass** der Stromkomparator eine vom Oszillator ausgegebene Frequenz empfängt und zur Frequenz des Oszillators komplementäre Impulse zur Ladungspumpe sendet, in Abhängigkeit vom Ergebnis des Vergleichs.

6. Integrierte Schaltung nach den Ansprüchen 4 und 5, **dadurch gekennzeichnet, dass** der zweite und der dritte Transistor identisch und wenigstens zehnmal kleiner als der Leistungstransistor sind.

7. Verfahren zum Regeln des Leckstroms eines Leistungstransistors (TP), der in Serie zwischen einem Versorgungsanschluss (A) und einem Verbraucherkreis (CA) geschaltet ist, wobei das Gate des Leistungstransistors eine Vorspannung in Durchlassrichtung im Leitungsmodus und eine Übervorspannung in Sperrrichtung (Vg) im Sperrmodus empfängt, wobei das Verfahren die Verwendung eines Oszillators (OSC) und einer Ladungspumpe (CHP) beinhaltet, die vom Oszillator Impulse empfängt, um die Übervorspannung in Sperrrichtung zu erzeugen, **dadurch gekennzeichnet, dass** der Oszillator ein Oszillator mit einer durch einen Strom geregelten Frequenz ist und der Steuerstrom (Ic) des Oszillators ein Drain-Strom eines Hilfstransistors (M0) ist, mit technischen Kennwerten, die für den Leistungstransistor repräsentativ sind, dessen Gate und Source jeweils mit dem Gate und der Source des Leistungstransistors verbunden sind.

8. Verfahren zum Regeln von Leckstrom nach Anspruch 7, **dadurch gekennzeichnet, dass** die vom Oszillator (OSC) ausgegebenen Impulse an die Ladungspumpe (CHP) unter der Steuerung eines Stromkomparators (CMP) angelegt werden, der die Leckströme eines zweiten (MA) und eines dritten (MB) Hilfstransistors vergleicht, die technische Kennwerte haben, die für die des Leistungstransistors repräsentativ sind, wobei die Source und das Gate des zweiten Hilfstransistors mit der Source und dem Gate des Leistungstransistors verbunden werden und sein Drain mit einem ersten Eingang des Stromkomparators verbunden wird, und wobei das Gate des dritten Hilfstransistors mit dem Gate des Leistungstransistors verbunden wird und seine Source und sein Drain miteinander und mit einem zweiten Eingang des Stromkomparators verbunden werden.
